(19) Europäisches Patentamt
European Patent Office
Office européen des brevets

(11) **EP 1 420 346 A2**

(12) **EUROPÄISCHE PATENTANMELDUNG**

(43) Veröffentlichungstag:
**19.05.2004 Patentblatt 2004/21**

(51) Int Cl.⁷: **G06F 17/17**

(21) Anmeldenummer: 03013886.1

(22) Anmeldetag: **20.06.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **14.10.2002 DE 10248543**

(71) Anmelder: **Deutsche Telekom AG**
**53113 Bonn (DE)**

(72) Erfinder:
• **Huber, Klaus, Dr.**
**64283 Darmstadt (DE)**
• **Knospe, Heiko, Dr. rer. nat.**
**50672 Köln (DE)**

(54) **Verfahren zur zweidimensionalen Darstellung, Interpolation und zur Kompression von Daten**

(57) Das Verfahren ist geeignet zur Repräsentation, Interpolation, zur Glättung und zur Kompression von Daten. Das Besondere ist die Anwendbarkeit von funktionentheoretischen Methoden, die ermöglicht wird durch Erfüllung der Cauchy-Riemannschen Bedingungen. Geeignet ist auch eine auf dem Sinus Lemniskatus beruhende Interpolationsformel, die auf der Funktion $sl(z)/z$ beruht, wie sie später beschrieben wird, die in den beiden Dimensionen (x-, y-Achse) identische Interpolationsfunktionen liefert.

Durch Anwendung der Cauchyschen Integralsätze kann die neue Darstellung für die Kompression von Daten genutzt werden.

Fig. 2

EP 1 420 346 A2

**Beschreibung**

Die Erfindung betrifft Verfahren zur mehrdimensionalen Darstellung, Interpolation und Kompression von Daten. Im Einzelnen handelt es sich um die Verwendung von zweidimensionalen Abtastfunktionen, die über den komplexen Zahlen definiert sind, um Daten effizient darzustellen, zu interpolieren, zu glätten oder zu komprimieren.

Gebiet der Erfindung:

Im Bereich der Datenverarbeitung ist es häufig notwendig, Daten zu komprimieren, um die Übertragung zu beschleunigen oder die Verarbeitung zu verbessern. So gibt es eine Reihe von Kompressions-Algorithmen, die Interpolationsverfahren verwenden. Zu nennen sind hier bekannte Kompressionsverfahren für Bilder, wie JPEG.

Aufgabe der Erfindung:

Aufgabe der Erfindung ist es, ein Verfahren bereitzustellen, das eine effiziente Kompression von Informationen ermöglicht, wobei Interpolationsalgorithmen eingesetzt werden, die besonderen Ansprüchen genügen.

Lösung der Aufgabe:

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet.

Das Besondere der hier benutzten Verfahren ist die Verwendung von holomorphen oder meromorphen Funktionen. Eine detaillierte Beschreibung dieser Fachtermini kann z. B. A. Hurwitz, Vorlesungen über allgemeine Funktionentheorie und Elliptische Funktionen, Fünfte Auflage, Springer, Berlin Heidelberg New-York, 2000, entnommen werden. Ist eine Funktion in einer offenen Teilmenge komplex differenzierbar, so heißt die Funktion auf dieser Teilmenge holomorph. Eine Funktion ist meromorph, wenn eine Funktion in einem beschränkten Gebiet in den komplexen Zahlen höchstens endlich viele Pole hat und die Funktion außerhalb dieser Pole holomorph in den komplexen Zahlen ist.

Für solche Funktionen gelten Sätze aus der Funktionentheorie, die für die zweidimensionale Signalverarbeitung und Signalkompression nutzbar gemacht werden können. In besonderer Weise gilt dies für eine auf dem Sinus Lemniskatus (siehe Gauss, Mathematisches Tagebuch 1796-1814, Harri Deutsch, 1985) beruhende zweidimensionale Abtastfunktion, deren Verhalten für Abtast- und Interpolationszwecke außergewöhnlich gut geeignet ist.

Das Verfahren ist geeignet zur Interpolation, zur Glättung und zur Kompression von Daten. Das Besondere ist die Anwendbarkeit von funktionentheoretischen Methoden, die ermöglicht wird durch Erfüllung der Cauchy-Riemannschen Bedingungen. Geeignet ist auch eine auf dem Sinus Lemniskatus beruhende Interpolationsformel, die auf der Funktion $sl(z)/z$ beruht, wie sie später beschrieben wird, die in den beiden Dimensionen (x-, y-Achse) identische Interpolationsfunktionen liefert.

Durch Anwendung der Cauchyschen Integralsätze und des Residuensatzes kann die neue Darstellung für die Kompression von Daten genutzt werden.

Detaillierte Beschreibung:

Ein Punkt $P=(x,y)$, der durch die reellen Werte $x$ und $y$ in kartesischen Koordinaten gegeben ist, wird zunächst als komplexe Zahl $z=x+i*y$ dargestellt, wobei $i$ die Quadratwurzel aus $-1$ ist.

Es wird der Fall der äquidistanten Abtastung betrachtet, d. h. die Werte $z_j$, für die Abtastwerte vorliegen, liegen auf den Schnittpunkten eines Gitters. Der Einfachheit normiere man auf den Einheitsabstand und nehme als Menge der Abtastpunkte eine Teilmenge der sogenannten Gaussschen ganzen Zahlen. Die Gaussschen ganzen Zahlen sind diejenigen komplexen Zahlen, deren Real- und Imaginärteile ganze Zahlen sind. Die Werte von zweidimensionalen Funktionen $s(z)$ an den Abtastwerten $z_j$ sind gegeben durch $s_j$. Die Werte $s_j$ gehören meist den komplexen Zahlen oder den reellen Zahlen an bzw. endlichen Approximationen dieser Zahlen, wie sie für die Informationsverarbeitung in technischen Geräten verwendet werden.

Eine wesentliche Eigenschaft der in dieser Erfindung betrachteten Funktionen $s(z)$ ist, dass sie die Cauchy-Riemannschen Differentialgleichungen erfüllen, außer bei ggf. vorhandenen Polstellen, d. h. sie sind holomorph oder meromorph.

Die Erfüllung dieser Gleichungen ist die Grundbedingung dafür, dass die sogenannten Cauchyschen Integralsätze bzw. der Residuensatz gelten. Zufolge dieses Satzes ist es möglich, die Werte von $s(z)$ innerhalb einer geschlossenen Kurve C, durch die Werte der Funktion $s(z)$ auf dem Rand der von C begrenzten Fläche auszurechnen. Dies eröffnet eine ganze Reihe von neuen Möglichkeiten bei der

Darstellung, der Interpolation und bei der Kompression von Daten.

Zur Benutzung als Funktion $s(z)$ sind insbesondere Funktionen geeignet, die mindestens über der Menge der Abtastpunkte $z_j$ Nullstellen haben, außer an der Stelle $z=0$. Hierzu gehören zum Beispiel geeignet gewählte Polynome.

Im Folgenden werden die vorteilhaften Eigenschaften von $a(z)$ zusammengefasst:

1. Es gilt $a(z)=1$ bzw. eine andere geeignete Konstante.

2. Es gilt $a(z_j)=0$, wobei $z_j \neq 0$ eine Gausssche ganze Zahl ist.

3. Die Funktion ist holomorph, außer an ggf. auftretenden Polstellen.

Die Funktion $s(z)$ wird nun dargestellt mittels

$$s(z)=\Sigma s_j \cdot a(z-z_j).$$

Geeignet für a(z) sind zahlreiche Funktionen, die Nullstellen mindestens an den Abtaststellen haben. Darüber hinaus ist es, um Funktionen zu erhalten, die sich bei der Interpolation und Approximation geeignet verhalten, günstig, wenn die Untermenge der Gaussschen ganzen Zahlen, die Nullstellen der Funktion $a(z)$ sind, sich noch über die Abtastwerte $z_j$ hinaus mindestens bis zur Kurve $C$ erstrecken.

Für praktische Anwendungen besonders geeignet ist eine Funktion, die mittels des *Sinus Lemniskatus* gebildet wird. Der Sinus Lemniskatus ist eine von Gauss eingeführte Funktion (siehe Gauss, Mathematisches Tagebuch 1796-1814, Harri Deutsch, 1985), die ähnlich der bekannten Sinusfunktion ist und sich mit Hilfe der wohlbekannten Jacobi elliptischen Funktionen darstellen lässt. Es gilt z. B.

$$Sl(z)=(1/\sqrt{2})\cdot sd(\sqrt{2}z,1/\sqrt{2}),$$

wobei *sd* z. B. mit den Standardfunktionen sn und dn wie folgt ausgedrückt werden kann: $sd(z,k)=sn(z,k)/dn(z,k)$ (siehe etwa E.T.Whittaker, G.N.Watson, A course of modern analysis, fourth edition, Cambridge, reprinted 1969, Seite 524).

Mit dem Sinus Lemniskatus, abgekürzt $sl(z)$, kann man in Erweiterung der wohlbekannten eindimensionalen Abtastfunktion $sin(\pi x)/(\pi x)$ (siehe etwa C. Shannon, Communication in the presence of noise, Proceedings Institute of Radio Engineers, Vol. 36, 1948, pp. 10-21), eine zweidimensionale Abtastfunktion

$$a(z) = \frac{sl(\bar{\pi}z)}{\bar{\pi}z}$$

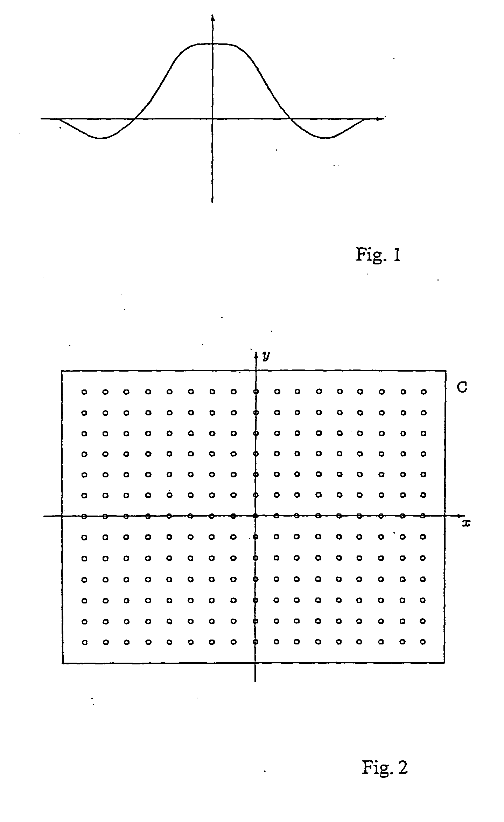

bilden. Die Rolle von $\pi$ bei der eindimensionalen Abtastfunktion übernimmt der Wert $\bar{\pi} \approx 2.622057554$. Die Funktion $a(z)$ ist in Figur 1 für reelle $z=x$ im Bereich $-2 < x < 2$ bildlich dargestellt.

Das bemerkenswerte der Funktion $a(z)$ ist, dass gilt $a(iz)=a(z)$, d. h. sie ist in der komplexen Ebene 90 Grad rotationsinvariant. Insbesondere liefert die Funktion für rein imaginäre Werte die gleichen Werte wie für reelle Werte, hat also die für die zweidimensionale Interpolation sehr günstige Eigenschaft, dass die Abtastfunktion in beiden Dimensionen identisch ist.

Dies ist eine Eigenschaft, die man bei der klassischen Abtastfunktion nicht findet, denn die klassische Sinusfunktion lässt sich bei rein imaginären Argumenten mit der Exponentialfunktion sinh darstellen.

Von besonderem Vorteil bei der Abtastung und Interpolation ist das sehr gutartige Verhalten von $sl(z)/z$. Dies zeigt auch die sogenannte Fouriertransformation.

Anhand der Fouriertransformation kann man erkennen, dass die Funktion von den Frequenzanteilen her sehr nahe am idealen Tiefpassverhalten der Funktion $sin(x)/x$ ist.

Nach den wohlbekannten Cauchyschen Integralsätzen können holomorphe Funktionen innerhalb einer geschlossenen Kurve durch die Werte auf dieser Kurve bestimmt werden. In Figur 2 ist ein entsprechendes typisches Szenario abgebildet.

Die Abtastpunkte $z_j$ sind durch kleine Kreise dargestellt. Mit Kenntnis der Funktion $s(z)$ bei den Abtastpunkten $z_j$, also $s(z_j)=s_j$ lässt sich die Funktion s(z) gemäß $s(z)=\Sigma s_j \cdot a(z-z_j)$ auch auf den Punkten der Kurve $C$ berechnen. Die Punkte auf der Kurve bezeichnet man mit der Variablen $\tau$.

Hat die Abtastfunktion $a(z)$ keine Pole innerhalb von $C$, so gilt mit dem Cauchyschen Integralsatz für die Werte $z$ innerhalb von $C$:

$$s(z) = \frac{1}{2\pi i} \oint_C \frac{s(\tau)d\tau}{\tau - z},$$

wobei das Kurvenintegral in mathematisch positiver Richtung durchlaufen wird.

Hat die Funktion $a(z)$ Pole, so kann durch Hinzuziehen der entsprechenden Residuen die Formel

$$s(z) = \frac{1}{2\pi i} \oint_C \frac{s(\tau)d\tau}{\tau - z}$$

mittels des wohlbekannten Residuensatzes erweitert werden.

Wesentlich dabei ist, dass die Punkte innerhalb von $C$ durch die Punkte $\tau$ auf der Kurve $C$ bestimmt werden können. Hiermit haben wir ein universelles Verfahren, um zweidimensionale Daten, aber auch allgemeine Daten, die als Werte $s_j$ bekannt sind, durch Werte auf der Kurve $C$ zu speichern.

Bei meromorphen Funktionen sind ggf. noch Residuen hinzuzuziehen. Die Weglänge auf der Kurve kann dabei z. B. zur Parametrisierung benutzt werden.

Je nach Redundanz der Daten $s_j$ gelingt es, mit weniger Daten auf der Kurve auszukommen. Hierdurch ergibt sich der Kompressionseffekt.

Anhand der folgenden Figuren wird die Erfindung mittels eines Beispiels beschrieben. Es zeigt:

Fig. 1  eine zweidimensionale Abtastfunktion $a(z)=sl(\bar{\pi}z)/(\bar{\pi}z)$;

Fig. 2  eine geschlossene Kurve $C$ mit Abtastpunkten innerhalb von $C$.

Fig. 3  den Realteil von $s(z)$ auf $C1$

Fig. 4  den Imagenärteil von $s(z)$ auf $C1$

Es werden die Punkte von Figur 2 betrachtet, wobei als Abtastwerte $s_j(z_j)$ die Werte der Funktion $s(z)$ $=si(\pi x/5)\cdot si(ny/5)$ genommen werden, wobei $z=x+iy$ und $si(x)=sin(x)/x$ gilt. Die komplexen Abtastpunkte $z_j$ sind die $17\cdot13$ = 221 Gaussschen ganzen Zahlen innerhalb der Kurve C.

Die Kurve C besteht aus den vier Geradenstücken $C_1$, $C_2$, $C_3$ und $C_4$.

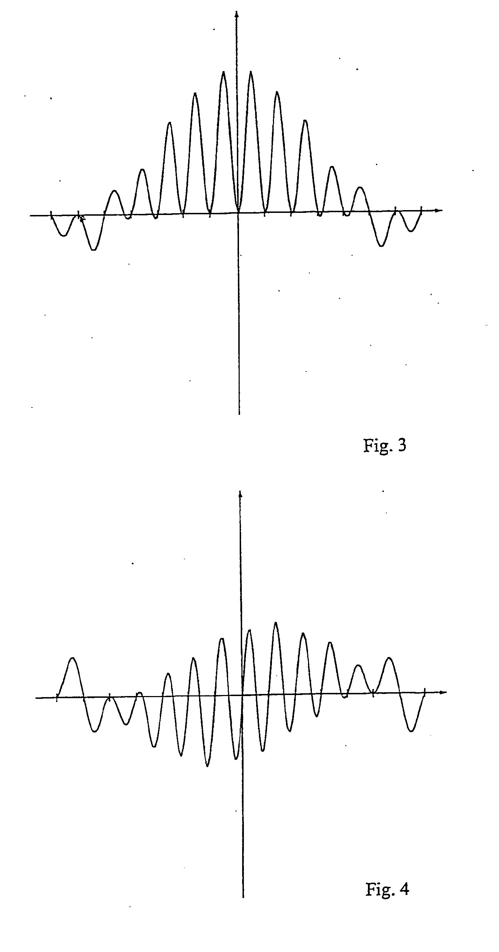

Die Strecke $C_1$ hat den Realteil $9$ und der Imaginärteil läuft von -7 bis 7. Der Realteil von $s(z)$ auf der Kurve $C_1$ ist in Figur 3 und der Imaginärteil von $s(z)$ in Figur 4 dargestellt. Der Verlauf auf den restlichen Kurvenstücken $C_{2,3,4}$ ist ähnlich.

Anhand der Bilder erkennt man, dass die Berechnung der Umlaufintegrale im Wesentlichen eine Tiefpassfilterung ist.

Liste der Literatur

1. Gauss, Mathematisches Tagebuch 1796-1814, Harri Deutsch, 1985.

2. C.Shannon, Communication in the presence of noise, Proceedings Institute of Radio Engineers, Vol. 36, 1948, pp.10-21.

3. A. Hurwitz, Vorlesungen über allgemeine Funktionentheorie und Elliptische Funktionen, Fünfte Auflage, Springer, Berlin Heidelberg New-York, 2000.

4. E.T.Whittaker, G.N.Watson, A course of modern analysis, fourth edition, Cambridge, reprinted 1969, Seite 524.

**Patentansprüche**

1. Verfahren zur Darstellung und/oder Interpolation und/oder Kompression von automatisch verarbeitbaren Daten, unter Verwendung einer zweidimensionalen Interpolationsformel $s(z)$, basierend auf einer Abtastfunktion $a(z)$, **dadurch gekennzeichnet, dass** für die Interpolationsformel der Cauchysche Integralsatz und ggf. der Residuensatz anwendbar sind.

2. Verfahren nach dem vorhergehenden Anspruch, **dadurch gekennzeichnet, dass** $a(z)$ eine Funktion über den komplexen Zahlen ist, für die gilt $a(0)=1$ und die mindestens an allen anderen in Betracht kommenden Abtastwerten $z_j=0$ ist.

3. Verfahren nach dem vorhergehenden Anspruch, **dadurch gekennzeichnet, dass** die Interpolationsformel $s(z)=\Sigma s_j a(z-z_j)$ sich an den komplexen Abtaststellen $z_j$ durch die Funktionswerte $s_j$ darstellen lässt.

4. Verfahren nach einem oder mehreren der vorhergehenden Ansprüche, **dadurch gekennzeichnet, dass** die Funktion $a(z)$ mit Hilfe von doppeltperiodischen und/oder quasidoppeltperiodischen komplexen Funktionen konstruiert wird.

5. Verfahren nach einem oder mehreren der vorhergehenden Ansprüche, **dadurch gekennzeichnet, dass** es sich bei der komplexen Funktion $a(z)$ um eine Funktion handelt, die holomorph ist.

6. Verfahren nach dem vorhergehenden Anspruch, **dadurch gekennzeichnet, dass** bei vorhandenen Polen die Funktion $a(z)$ nicht holomorph ist.

7. Verfahren nach einem oder mehreren der vorhergehenden Ansprüche, **dadurch gekennzeichnet, dass** die Abtastwerte der Funktion $s(z)$ im Innern einer geschlossenen Kurve C liegen.

8. Verfahren nach einem oder mehreren der vorhergehenden Ansprüche, **dadurch gekennzeichnet, dass** Funktionswerte von $s(z)$ für Punkte auf der Kurve C durch die Gleichung $s(z)=\Sigma s_j a(z-z_j)$ bestimmt werden.

9. Verfahren nach dem vorhergehenden Anspruch, **dadurch gekennzeichnet, dass** die Funktionswerte auf der geschlossenen Kurve $C$ mit Hilfe der Weglänge parametrisiert werden, sodass eine äquivalente eindimensionale Datenmenge erhalten wird.

10. Verfahren nach dem vorhergehenden Anspruch, **dadurch gekennzeichnet, dass** die Punkte von $s(z)$ im Innern der Kurve $C$ mittels des Cauchyschen Integralsatzes, und bei vorhandenen Polen mit weiterer Zuhilfenahme des Residuensatzes im Innern von $C$ mit Funktionswerten auf $C$ bestimmt werden.

11. Verfahren nach einem oder mehreren der vorhergehenden Ansprüche, **dadurch gekennzeichnet, dass** als Interpolationsfunktion die Funktion $a(z)=sl(\bar{\pi}z)/(\bar{\pi}z)$ benutzt wird.

12. Verfahren nach dem vorhergehenden Anspruch, **dadurch gekennzeichnet, dass** *sl(z)* der Sinus Lemniskatus ist, eine elliptische Funktion, die sich mit Hilfe der Jacobischen elliptischen Funktionen darstellen lässt.

**13.** Verfahren nach einem oder mehreren der vorhergehenden Ansprüche, **dadurch gekennzeichnet, dass** zur Kompression von Daten, die zu komprimierenden Daten in geeigneter Weise auf die Punkte im Innern der Kurve C abgebildet werden, insbesondere zeilenweise, um dann durch die Punkte auf einer zweidimensionalen geschlossenen Begrenzungskurve dargestellt zu werden, wobei die Darstellungen mittels der zweidimensionalen Interpolationsfunktion erhalten werden.

**14.** Software für einen Computer, **dadurch gekennzeichnet, dass** ein Verfahren nach einem oder mehreren der vorhergehenden Ansprüche implementiert ist.

**15.** Datenträger für einen Computer, **gekennzeichnet durch** die Speicherung einer Software nach dem vorhergehenden Softwareanspruch.

**16.** Computersystem, **gekennzeichnet durch** eine Einrichtung, die den Ablauf eines Verfahrens nach einem oder mehreren der vorhergehenden Verfahrensansprüche erlaubt.

Fig. 1

Fig. 2

Fig. 3

Fig. 4